# EUROPÄISCHE PATENTSCHRIFT

(11) **EP 0 601 151 B1**
(45) Veröffentlichungstag und Bekanntmachung des Hinweises auf die Patenterteilung: **13.11.1996**
(21) Anmeldenummer: 93912611.6
(22) Anmeldetag: 22.06.1993
(51) Int. Cl.: H01J 37/32, C23C 16/50

(54) **VERFAHREN ZUR REGELUNG EINER GLÜHKATODENGLIMMENTLADUNG**
PROCESS FOR REGULATING A HOT CATHODE GLOW DISCHARGE
PROCEDE DE REGULATION DE LA DECHARGE LUMINEUSE D'UNE CATHODE CHAUDE

(30) Priorität: 29.06.1992 DE 4221360
(43) Veröffentlichungstag der Anmeldung: 15.06.1994
(73) Patentinhaber: VTD-Vakuumtechnik Dresden GmbH, D-01242 Dresden (DE)
(72) Erfinder: GRIMM, Werner, D-01326 Dresden (DE); BÜCKEN, Bernd, D-01277 Dresden (DE); CERNOHORSKY, Hagen, D-01159 Dresden (DE); EHRLICH, Ulrike, D-01796 Pirna (DE)
(74) Vertreter: Pätzelt, Peter, Dipl.-Ing. Patentanwalt
(86) Internationale Anmeldenummer: DE9300544
(87) Internationale Veröffentlichungsnummer: WO9400867

(56) Entgegenhaltungen:
- US-A- 3 344 055
- US-A- 5 114 559
- NACHRICHTEN TECHNIK ELEKTRONIK Bd. 26, Nr. 11, 1976, BERLIN DD Seiten 408 - 409 H. HOFMANN ET AL. 'Die Glimmentladung ein Verfahren zur Herstellung von dünnen organischen Polymerschichten.'

## Beschreibung

### Technisches Gebiet

Die Erfindung betrifft ein Verfahren zur Regelung einer Glühkatodenglimmentladung für die Plasmapolymerisation von monomerem Dampf organischer Verbindungen, vorzugsweise von siliziumorganischen Substanzen.

Die Plasmapolymerisation ist ein Vakuumbeschichtungsverfahren, welches die Abscheidung von dünnen organischen Schichten aus der Dampfphase ermöglicht. Durch Plasmapolymerisation abgeschiedene Schichten sind durch gute Kratz- und Wischfestigkeit sowie optische Transparenz gekennzeichnet. Sie sind des weiteren dicht gegen aggressive Lösungen und Gase.

### Stand der Technik

Industriell durchgesetzt hat sich die Plasmapolymerisation bei der Abscheidung von organischen Schutzschichten auf Reflektoren, vgl. G.Benz, "Schutzschichten durch Plasmapolymerisation", Bosch Techn. Berichte 8(1986/87/-)5, S.219-226. Bei der Verwendung silizium- und sauerstoffhaltiger Monomere, z.B. Hexamethyldisiloxan (HMDS), besteht die Möglichkeit, Schichten herzustellen, deren chemische Struktur und Eigenschaften glasähnlich sind. Aufgrund ihrer Dichtigkeit gewährleisten sie die Korrosionsbeständigkeit der darunter liegenden Reflexionsschicht. Gegenüber naßchemischer Beschichtungsverfahren, mit denen ebenfalls transparente Schutzschichten auf Reflektoren hergestellt werden können, sind die Verfahren der Plasmapolymerisation mit deutlich geringeren sicherheits- und umwelttechnischen Problemen verbunden. Die Wirtschaftlichkeit der Plasmapolymerisation wird insbesondere durch die preiswerten Materialien, wie Äthylen oder Hexamethyldisiloxan beeinflußt, und es lassen sich ökonomisch sinnvoll hochwertige neue Oberflächeneigenschaften erzielen.

Die wichtigsten Verfahren zur Plasmapolymerisation sind die Glühkatodenglimmentladung, die Hochspannungsentladung, die Hochfrequenzentladung und die Mikrowellenentladung, vgl. A.Rutscher, H.Deutsch, "Plasmatechnik" Carl Hanser Verlag, München (1984) S.324-335. Bereits frühzeitig fand die relativ einfache Glühkatodenglimmentladung breite Anwendung, vgl. z.B. W.Möller u. a.: "Glimmpolymerschichten für Korrosionsschutzzwecke" in "Hochvakuum, Grenzflächen/Dünne Schichten" Bd.II S.261-264, 8.Tagung in Dresden (3/1984).

Im Laufe der Entwicklung dieses Verfahrens zeigten sich jedoch zunehmend Mängel und Probleme bei der Einhaltung bestimmter Schichtqualitäten. J.Leiber, M.Londschien, K.Telgenbüscher und W.Michaeli erläutern in dem Aufsatz "Plasmapolymerisation - Ein Verfahren für viele Anwendungen" in "Vakuum in der Praxis" (1992) Nr.1, S.22-29, auf S. 24, daß "... große Versuchsreihen erforderlich sind, um die jeweils gewünschten Schichteigenschaften zu erzielen und zu optimieren."

Bei der praktischen Anwendung des Verfahrens der Plasmapolymerisation mit Glühkatoden wurde festgestellt, daß es bei den komplizierten Prozessen der Plasmapolymerisation zu Alterungserscheinungen der Glühkatoden kommt, was zu erheblichen Schwankungen der Schichtabscheiderate führt und damit zu Beeinträchtigungen der Schichthomogenität und Schichtqualität. Die Reproduzierbarkeit der Qualitätsparameter im industriellen Prozeß ist nicht gesichert. Als Gegenmaßnahme nach dem Stand der Technik wird versucht, durch Vorglühen der Glühkatoden deren Standzeit bzw. Alterungsbeständigkeit zu verbessern. Der erreichbare positive Effekt ist gering, so daß als Alternative die Glühkatoden bewußt vorzeitig ausgewechselt werden. Teilweise wird auch durch Nachregulieren der Parameter per Hand versucht, die Standzeit der Glühkatoden zu verlängern.

Bei der Plasmapolymerisation mit der Mikrowellenentladung können gleichmäßigere Schichten abgeschieden werden, jedoch ist zu beachten, daß der technische Aufwand für diese Verfahren wesentlich höher ist. Zusätzlich wird die Anwendung der Mikrowellenentladung dadurch eingeschränkt, daß die praktisch nutzbare Plasmazone räumlich relativ begrenzt ist.

### Darstellung der Erfindung

Der Erfindung liegt die Aufgabe zugrunde, ein Verfahren zur Regelung einer Glühkatodenglimmentladung für die Plasmapolymerisation von monomerem Dampf organischer Verbindungen, vorzugsweise von siliziumorganischen Substanzen, zu schaffen, bei dem Schwankungen in der Schichtabscheiderate weitgehend vermieden werden und die Schichtqualität wesentlich verbessert wird.

Die Erfindung löst die Aufgabe mit dem in Anspruch 1 angegebenen Verfahren.

Erfindungsgemäß wird die systematische Veränderung der Glimmspannung durch Alterungsprozesse der Glühkatode mittels eines langsamen Nachregulierens des Glühkatodenstromes zielgerichtet korrigiert. Erfindungswesentlich ist das langsame Nachregulieren und Einstellen eines Heizstromes der Glühkatode vor dem Einsetzen der eigentlichen Glimmpolymerisation, während die Glühkatodenglimmentladung vorerst in einer Edelgasatmosphäre brennt, bis sich eine erste Glimmspannung U₁ als Sollwert einstellt. In gleicher Weise wichtig ist das langsame Nachregeln des Heizstromes während der Glimmpolymerisation im Monomer-Edelgas-Gemisch, so daß eine zweite Glimmspannung U₂ erreicht und konstant gehalten wird. Der monomere Dampf der organischen Verbindung wird erst dann eingelassen und die Plasmapolymerisation eingeleitet, wenn die aktuellen Veränderungen durch Alterungsprozesse der Glühkatode in inerter Atmosphäre ausgeglichen sind. Die Glimmspannung wird während der Plasmapolymerisation konstant auf dem Wert U₂ gehalten. Sie liegt vorteilhaft etwa 10 bis 40 % unter der Glimmspannung U₁, die in inerter Atmosphäre voreingestellt wurde. Je nach Aufgabe liegt die Glimmspannung U₂ während der Plasmapolymerisation zwischen 40 bis 70 V.

Der Monomerdampf wird, unter Beibehaltung des Edelgaseinlasses in die Vakuumkammer während der Plasmapolymerisation, lediglich zugemischt. Der Edelgasanteil wirkt sich günstig auf die Härte der abgeschiedenen Schicht aus.

Wesentlich ist die erfindungsgemäß langsame Nachregulierung des Glühkatodenstromes, damit für das Verfahren unbedeutende kurzzeitige Spannungsänderungen nicht in den Regelungsprozeß einbezogen werden. Die Änderungsgeschwindigkeit des Glühkatodenstromes beträgt maximal zwischen 5 und 15 % seines Wertes innerhalb von 5 bis 10 Minuten.

Die Alterungsprozesse der Glühkatode werden sehr wesentlich auch von den Abscheidungen des monomeren Dampfes der organischen Verbindung auf der Glühkatode beeinflußt. Deshalb wird am Ende der Plasmapolymerisation, nach dem Schließen der Ventile zum Einlassen des monomeren Dampfes, die Glühkatodenglimmentladung bei einer dritten Glimmspannung U₃ fortgesetzt, die höher liegt als die Glimmspannung U₂, bis der monomere Dampf innerhalb der Vakuumkammer weitgehend aufgezehrt ist. Die Glimmspannung U₃ entspricht dabei etwa der Glimmspannung U₁, Damit wird in dieser Schlußphase verhindert, daß sich polymere Abscheidungen auf der Glühkatode absetzen.

Mit dem erfindungsgemäßen Verfahren werden die Alterungsprozesse der Glühkatode wesentlich verlangsamt und die Standzeit der Glühkatode erhöht. Im besonderen Maße werden die Schwankungen in der Schichtabscheiderate, wie sie beim Stand der Technik auftreten, unterdrückt und die Homogenität der Schicht sowie die Qualität deutlich verbessert.

Die Erfindung soll nachstehend an einem Ausführungsbeispiel näher erläutert werden.

Die zugehörige Zeichnung zeigt schematisch eine Vakuumkammer mit den zugehörigen Stromversorgungs- und Regelungseinrichtungen.

In dem Ausführungsbeispiel soll das erfindungsgemäße Verfahren an einem Beispiel zur Beschichtung von Reflektoren mit einer wischfesten, durch Plasmapolymerisation abgeschiedenen, Hexamethyldisiloxanschicht beschrieben werden. Die Schutzschicht soll die Korrosionsbeständigkeit der Reflektoren gewährleisten.

Die zugehörige Vakuumeinrichtung besteht aus einer Vakuumkammer 1, die über den Flansch 2 durch ein Vakuumpumpensystem evakuiert wird. Die zu beschichtenden Substrate 3 sind in einem Drehkorb 4 im oberen Teil der Vakuumkammer 1 angeordnet. Im unteren Teil der Vakuumkammer 1 befindet sich ein Widerstandsverdampfer 5 sowie eine Glühkatode 6 mit einem zugehörigen Anodengitter 7. Unterhalb des Drehkorbes 4 befindet sich noch eine Glimmelektrode 8. Das für die Prozeßführung erforderliche Inertgas, im Beispiel Argon, wird über das Regelventil 9 und der Monomerdampf über das Regelventil 10 zugeführt . Die einzelnen Elemente zur Steuerung und Regelung der Prozesse sind in der Steuerung 11 baugruppenmäßig zusammengefaßt. Die erforderlichen Stromversorgungen sind als selbständige Einheiten dargestellt.

Nachfolgend wird das erfindungsgemäße Verfahren im Zusammenhang einer kompletten Substratbeschichtung näher beschrieben.

In bekannter Weise wird zuerst die Vakuumkammer 1 auf einen Druck von ca. 1 mbar evakuiert. Danach wird über das Regelventil 9 Argon in die Vakuumkammer 1 eingelassen und im Zusammenspiel mit dem Vakuumpumpensystem über den Flansch 2 ein Arbeitsdruck in der Vakuumkammer 1 von 50 mbar eingestellt. Danach folgt für die Vorbereitung der Substrate 3, im Beispiel Reflektoren, zur Beschichtung ein Ionenreinigungsprozeß. Dazu wird die Glimmelektrode 8 mit einer Spannung von max. 2 kV beauflagt, und es kommt zu einer Glimmentladung mit einem Strom von max. 500 mA. Je nach dem eingesetzten Material der Substrate 3 wird die Glimmentladung etwa bis 10 min aufrechterhalten. Die Oberflächen der Substrate 3 werden dadurch derart gereinigt, daß im nachfolgenden Arbeitsgang eine Spiegelschicht aus Aluminium haftfest abgeschieden werden kann. Dazu wird der Zustrom von Argon über das Regelventil 9 unterbrochen und der Vakuumrezipient 1 wird auf einen Arbeitsdruck von kleiner 1 x 10⁻⁴ mbar evakuiert. Mittels des Widerstandsverdampfers 5 wird in bekannter Weise Aluminium in der erforderlichen Menge verdampft, welches sich auf der Oberfläche der Substrate 3 niederschlägt. Auf den Substraten 3 wird eine hochreflektierende Aluminiumschicht abgeschieden, die nach etwa 30 s optisch dicht ist. Die Dicke der Aluminiumschicht richtet sich nach den technologischen Vorgaben für den Reflektor. Nachdem die Abscheidung der Aluminiumschicht auf dem Substrat 3 abgeschlossen ist, wird über das Regelventil 9 erneut Argon eingelassen und ein Arbeitsdruck von ca. 4 x 10⁻⁴ mbar eingestellt. Nachfolgend werden die erfindungsgemäßen Verfahrensschritte realisiert. Über die Steuerung 11 wird die Stromquelle 12 für die Glühkatode 6 zugeschaltet. Die Reglerbaugruppe 13 steuert die Stromquelle 12 derart, daß ein vorbestimmter Glühkatodenstrom von 80 A als Startwert eingestellt wird. Nach einer Verzögerung von ca. 1/2 min wird die Stromquelle 14 zugeschaltet. Die Stromquelle 14 liefert einen konstanten Strom von 10 A, der über die Glühkatodenglimmentladung, die sich zwischen der Glühkatode 6 und dem Anodengitter 7 ausbildet, fließt. Gleichzeitig beginnt über die Reglerbaugruppe 13 die Regelung des Glühkatodenstromes in erfindungsgemäßer langsamer Nachregelung bis die Spannung über die Glühkatodenglimmentladung U₁ als Sollwert 75 V beträgt. Abhängig vom Alter bzw. dem Erosionsgrad der Glühkatode 6, stellt sich dabei ein Strom zwischen 70 bis 90 A ein. Nachdem die Spannung über der Glühkatodenglimmentladung den konstanten Wert von U₁ = 75 V erreicht hat, wird das Regelventil 10 geöffnet und als monomerer Dampf Hexamethyldisiloxan bis zu einem Arbeitsdruck von 8 mbar in der Vakuumkammer 1 eingelassen. Gleichzeitig wird über den Schalter 15 durch die Reglerbaugruppe 13 auf eine Sollwertvorgabe für die Spannung über die Glühkatodenglimmentladung von U₂ = 60 V umgeschaltet. Aufgrund der verzögerten, langsamen Arbeitsweise der Reglerbaugruppe 13 stellt sich dieser Spannungswert U₂ zwischen der Glühkatode 6 und dem Anodengitter 7 nach ca. 30 s ein. Das HMDS-Monomer dissoziiert innerhalb der Glühkatodenglimmentladung und wird insbesondere auf der vorher mit Aluminium beschichteten Oberfläche der Substrate 3 als feste, wischfeste und dichte Schicht eines stark vernetztes polysiloxanartiges Polymer abgeschieden. Die Abscheiderate beträgt etwa 10 nm/min. Die technologisch geforderten Schichtdicken der siliziumhaltigen glasähnlichen Schutzschicht für Reflektoren beträgt zwischen 50 und 70 nm. Wenn diese Schichtdicke erreicht ist, wird das Regelventil 10 geschlossen und auf eine Glimmspannung U₃ umgeschaltet, die höher liegt als die Glimmspannung U₂. Im Beispiel wird über den Schalter 15 von der Regelbaugruppe 13 wieder der U₁-Sollwert von 75 V vorgegeben und über die Stromregelung eingestellt. In dieser Phase, die ca. 1 min dauert, wird der restliche Monomerdampf in der Vakuumkammer 1 dissoziiert, bis er vollständig aufgezehrt ist. Gleichzeitig wird durch diese weitere Plasmaeinwirkung der zuvor auf den Substraten 3 abgeschiedene Schicht einer Nachverfestigung unterzogen. Wesentlich ist die möglichst absolute Reinigung der Glühkatode 6 von Produkten der Plasmapolymerisation. Abschließend werden die Stromquellen 14 und 12 abgeschaltet. Die Beschichtung der Substrate 3 ist abgeschlossen.

Mittels der erfindungsgemäßen Verfahrensführung, langsames Nachregeln der Spannung über die Glühkatodenglimmentladung durch langsames Nachregeln des Glühkatodenstromes, wird eine sehr gleichmäßige Plasmapolymerisation realisiert. Die abgeschiedene Schicht weist eine hohe Homogenität und damit hohe Schichtqualität auf, die sicher reproduziert werden kann. Mit Klimawechsel-, Schwitzwasser- und Natronlauge-Tests konnte eine hohe Korrosionsbeständigkeit der Reflektoren bestätigt werden.

Die Lebensdauer der Glühkatode wird um ein mehrfaches verlängert.

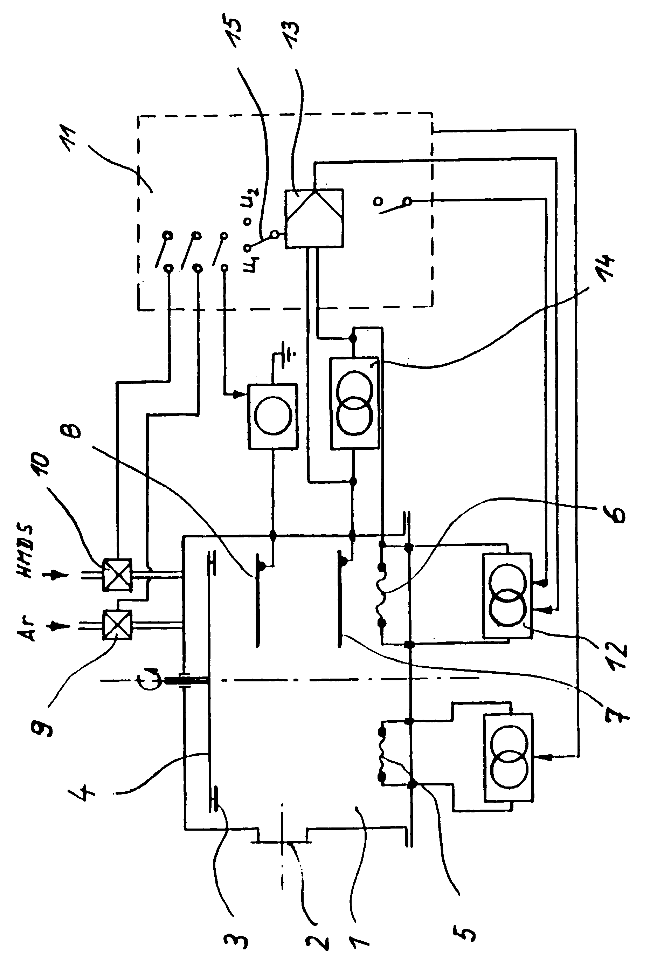

## Patentansprüche

1. Verfahren zur Regelung einer Glühkatodenglimmentladung zur Plasmapolymerisation von monomerem Dampf organischer Verbindungen, vorzugsweise einer siliziumorganischen Substanz, **dadurch gekennzeichnet,** daß zuerst ein Edelgas in die Vakuumkammer (1) eingelassen wird, daß ein vorbestimmter Glühkatodenstrom eingestellt und langsam nachreguliert wird, bis eine erste Glimmspannung U₁ als Sollwert erreicht ist, und daß danach der monomere Dampf eingelassen und eine konstante zweite Glimmspannung U₂ durch langsames Nachregeln des Glühkatodenstromes aufrechterhalten wird.

2. Verfahren nach Anspruch 1, **dadurch gekennzeichnet,** daß die Glühkatodenglimmentladung beendet wird, indem der Zustrom des monomeren Dampfes in die Vakuumkammer (1) unterbrochen und die Glühkatodenglimmentladung bei einer dritten Glimmspannung U₃ fortgesetzt wird, bis der monomere Dampf in der Vakuumkammer (1) weitgehend aufgezehrt ist.

3. Verfahren nach Anspruch 1, **dadurch gekennzeichnet,** daß die erste Glimmspannung U₁ etwa 10 bis 40 % über der zweiten Glimmspannung U₂ liegt, wobei die zweite Glimmspannung U₂ 40 bis 70 V beträgt.

4. Verfahren nach Anspruch 2, **dadurch gekennzeichnet,** daß die dritte Glimmspannung U₃ der ersten Glimmspannung U₁ entspricht.

5. Verfahren nach Anspruch 1, **dadurch gekennzeichnet,** daß der Glühkatodenstrom kontinuierlich mit einer Geschwindigkeit verändert wird, die maximal 5 bis 15 % seines Wertes innerhalb von 5 bis 10 Minuten beträgt.

## Claims

1. Method for regulating a hot cathode glow discharge for plasma polymerisation of monomer vapour of organic compounds, preferably of a silicium-organic substance, characterised in that a noble gas is first introduced into the vacuum chamber (1), that a predetermined hot cathode current is set and slowly readjusted until a first glow potential U₁ is achieved as a set value and that subsequently the monomer vapour is introduced and a constant second glow potential U₂ is maintained by slow readjustment of the hot cathode current.

2. Method according to claim 1, characterised in that the hot cathode glow discharge is ended in that the supply of the monomer vapour into the vacuum chamber (1) is interrupted and the hot cathode glow discharge is continued at a third glow potential U₃ until the monomer vapour in the vacuum chamber (1) is substantially exhausted.

3. Method according to claim 1, characterised in that the first glow potential U₁ is about 10 to 40% above the second glow potential U₂, wherein the second glow potential U₂ amounts to 40 to 70 V.

4. Method according to claim 2, characterised in that the third glow potential U₃ corresponds to the first glow potential U₁.

5. Method according to claim 1, characterised in that the hot cathode current is continuously changed at a rate which amounts to a maximum of 5 to 15% of its value within 5 to 10 minutes.

## Revendications

1. Procédé de régulation de la décharge lumineuse d'une cathode chaude servant à la polymérisation au plasma d'une vapeur monomère de composés organiques, de préférence une substance organique au silicium,
caractérisé en ce qu'
on introduit d'abord un gaz rare dans la chambre à vide (1), on règle le courant de la cathode chaude à une certaine valeur qui est ensuite régulée lentement jusqu'à ce que soit atteinte une première tension d'effluve (U₁) en tant que valeur de consigne, on introduit ensuite la vapeur monomère et par une régulation lente consécutive du courant de la cathode, on maintient constante une seconde tension d'effluve (U₂).

2. Procédé selon la revendication 1,
caractérisé en ce que
la décharge d'effluve de la cathode chaude est arrêtée en même temps que l'on interrompt l'arrivée de la vapeur monomère dans la chambre à vide (1), la décharge d'effluve de la cathode se poursuivant à un troisième niveau de tension (U₃) jusqu'à ce que la vapeur monomère ont été complètement consommée.

3. Procédé selon la revendication 1,
caractérisé en ce que
la première tension d'effluve (U₁) est supérieure de 10 à 40 % environ à la deuxième tension d'effluve (U₂) qui est de 40 à 70 Volts.

4. Procédé selon la revendication 2,
caractérisé en ce que
la troisième tension (U₃) est égale à la première (U₁).

5. Procédé selon la revendication 1,
caractérisé en ce que
le courant alimentant la cathode chaude varie continuellement à une vitesse qui fait évoluer sa valeur de 5 à 15 % dans un intervalle de temps de 5 à 10 minutes.
